# EUROPEAN PATENT SPECIFICATION

(11) **EP 4 525 037 B1**
(45) Date of publication and mention of the grant of the patent: **25.11.2026**
(21) Application number: 23913873.8
(22) Date of filing: 07.12.2023
(51) Int. Cl.: H10W 70/04, H10W 70/65, H10W 72/00

(54) **SEMICONDUCTOR CHIP PACKAGE AND MANUFACTURING METHOD THEREFOR**
HALBLEITERCHIPGEHÄUSE UND HERSTELLUNGSVERFAHREN DAFÜR
BOÎTIER DE PUCE SEMI-CONDUCTRICE ET SON PROCÉDÉ DE FABRICATION

(30) Priority: 26.07.2023 CN 202310935359
(43) Date of publication of application: 19.03.2025
(73) Proprietor: Diodes Incorporated, Plano, Texas 75024 (US); BCD Shanghai Micro-Electronics Company Limited, Shanghai 200240 (CN)
(72) Inventor: LIN, Shiau-Shi, Taoyuan City Taiwan 320677 (CN)
(74) Representative: Marks & Clerk LLP
(86) International application number: PCT/CN2023/136936
(87) International publication number: WO 2025/020417

(56) References cited:
- CN-A- 1 458 691
- JP-A- 2007 096 042
- JP-A- 2007 096 042
- JP-A- 2007 134 395
- JP-A- H0 661 276
- US-A1- 2006 175 689
- US-A1- 2006 175 689
- US-A1- 2016 260 657
- US-B2- 9 190 353
- ANONYMOUS: "Chip Carrier - Wikipedia", 21 June 2023 (2023-06-21), XP093267215, Retrieved from the Internet <URL:https://en.wikipedia.org/w/index.php?title=Chip_carrier&oldid=1161189083>
- QUEK YANG BOON: "Application Report SLOA122- July 2006 - QFN Layout Guidelines - HPL Audio Power Amplifiers", 1 January 2006 (2006-01-01), pages 1 - 7, XP093342842, Retrieved from the Internet <URL:https://www.ti.com/lit/an/sloa122/sloa122.pdf?ts=1764676790574&ref_url=https%3A%2F%2Fwww.google.com%2F> [retrieved on 20251202]

## Description

### TECHNICAL FIELD

The present disclosure relates to semiconductor chip package and manufacturing method thereof, and in particular, to a semiconductor chip package having a lead frame.

### BACKGROUND

A semiconductor chip can be mounted on a chip pad of a lead frame by use of adhesive, and electrically connected to lead contacts of the lead frame by use of conductive wires. A molding compound may then be formed to encapsulate the power chip and the lead frame. With miniaturization of the package structures, the area of the chip pad is reduced, and the distance from the power chip to the edge of the chip pad is also shortened, which may cause the adhesive to overflow. In addition, lead frames are typically thin and have fine patterns, and may be damaged or deformed by mechanical or thermal force during the manufacturing process. One objective of the present invention is to avoid the adhesive overflow and improve the stability of lead frames, so as to improve manufacturing quality.

JP2007-096042A discloses a semiconductor device which comprises a semiconductor chip and islands to which the semiconductor chip is die-bonded through a die-bonding material. The island has a die-bonding region to which the semiconductor chip is die-bonded. A recess having a smaller opening area than the backside area of the semiconductor chip is formed in the die-bonding region, and the die-bonding material is located between the entire backside of the semiconductor chip and the die-bonding region.

JP2007-134395A discloses similar subject matter to JP2007-096042A.

US2016/260657A1 discloses a semiconductor package in which surfaces of a die pad, a semiconductor element, a connecting member, and a lead are subjected to a surface treatment with a silane coupling agent. A first surface of a plurality of surfaces of the semiconductor device includes a first region where an organic substance is exposed, and a second region where an inorganic substance is exposed, the first surface being bonded with the connecting member.

"Chip Carrier - Wikipedia", 21 June 2023, XP093267215, discloses that in electronics, a chip carrier is one of several kinds of surface-mount technology packages for integrated circuits (commonly called "chips"). Connections are made on all four edges of a square package; compared to the internal cavity for mounting the integrated circuit, the package overall size is large.

### SUMMARY

A first aspect of the current disclosure relates to a semiconductor chip package according to claim 1 and a second aspect to a manufacturing method of a semiconductor chip package according to claim 11.

### BRIEF DESCRIPTION OF THE DRAWINGS

Aspects of embodiments of the present disclosure may best be understood from the following detailed description when read in conjunction with accompanying drawings. It should be noted that various structures may not be drawn to scale. In fact, the dimensions of the various structures may be enlarged or reduced at will for clarity of illustration.
FIG. 1A is a perspective view of a portion of a semiconductor chip package according to some embodiments of the present disclosure;
FIG. 1B is a perspective view of a portion of a semiconductor chip package according to some embodiments of the present disclosure;
FIG. 1C is a cross-sectional view of a semiconductor chip package according to some embodiments of the present disclosure;
FIG. 2A and FIG. 2B illustrate one or more stages in a manufacturing method of a semiconductor chip package according to some embodiments of the present disclosure;
FIGs. 3A-1, 3A-2, 3B, 3C, 3D-1, 3D-2, 3E-1, 3E-2, 3F, 3G, and 3H illustrate one or more stages in a manufacturing method of a semiconductor chip package according to some embodiments of the present disclosure;

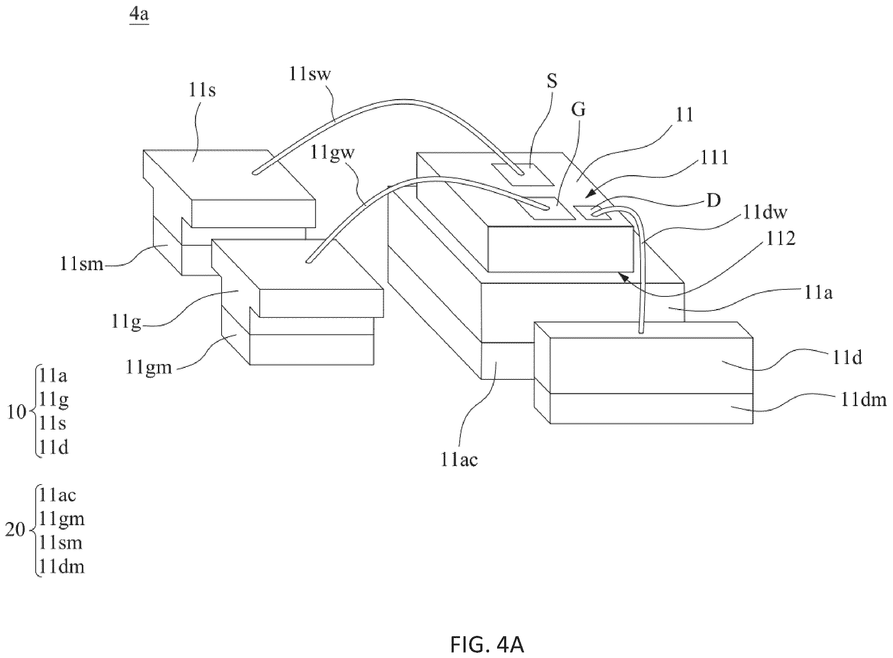

FIG. 4A is a perspective view of a portion of a semiconductor chip package according to some embodiments of the present disclosure; and

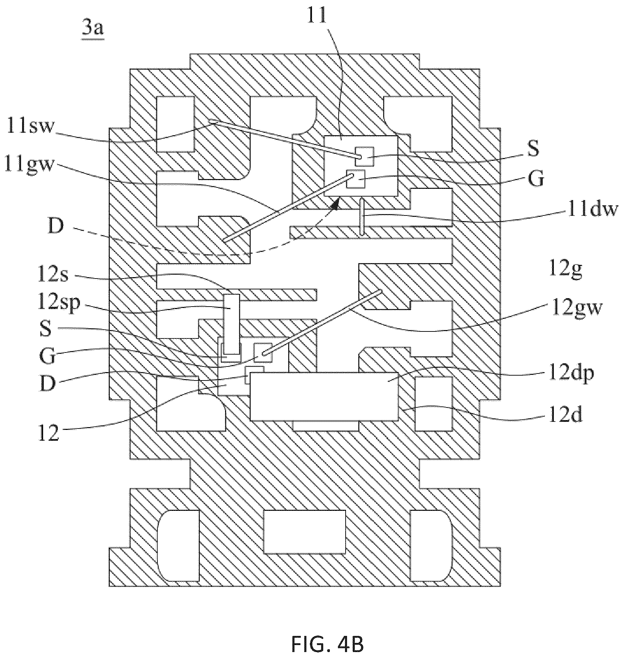

FIG. 4B illustrates one or more stages in a manufacturing method of a semiconductor chip package according to some embodiments of the present disclosure.

Identical or similar components are labeled with the same reference numbers in the drawings and detailed description. Embodiments of the present disclosure will be readily understood from the following detailed description taken in conjunction with the accompanying drawings.

### DETAILED DESCRIPTION OF ILLUSTRATIVE EMBODIMENTS

The following disclosure provides various different embodiments or examples for implementing different features provided. Specific embodiments of components and configurations are described below. Certainly, these are examples only and are not intended to be limiting. In the present disclosure, references to forming a first feature above or on a second feature may include embodiments where the first and second features are formed in direct contact, and may also include embodiments where an additional feature is formed between the first feature and the second feature such that the first feature and the second feature may not be in direct contact. In addition, the present disclosure may repeat reference signs and/or letters of the drawings in various embodiments. Such repetition is for simplicity and clarity and does not in itself indicate a relationship between the various embodiments and/or configurations discussed.

Embodiments of the present disclosure are discussed in detail below. It should be appreciated, however, that the present disclosure provides applicable concepts that can be embodied in a wide variety of specific contexts. The specific embodiments discussed herein are illustrative only, and do not limit the scope of the present disclosure.

The present disclosure provides a semiconductor chip package and a manufacturing method thereof.

In the semiconductor chip package of the present disclosure, a semiconductor chip is mounted on a chip pad of a lead frame through an adhesive, and may be electrically connected to lead contacts of the lead frame via conductive members (e.g., wires or copper strips). The adhesive is filled in a groove of the chip pad. This prevents the adhesive from overflowing and improves stability of the lead frame, thereby improving the manufacturing yield. In addition, in the manufacturing process of the semiconductor chip package of the present disclosure, a clamp may be used to fix the lead frame on a carrier, to avoid causing wireframe warping. The part of the carrier that is used to carry the chip pad may be made of a material having a relatively high thermal conductivity, which improves the thermal conductivity of the semiconductor chip package.

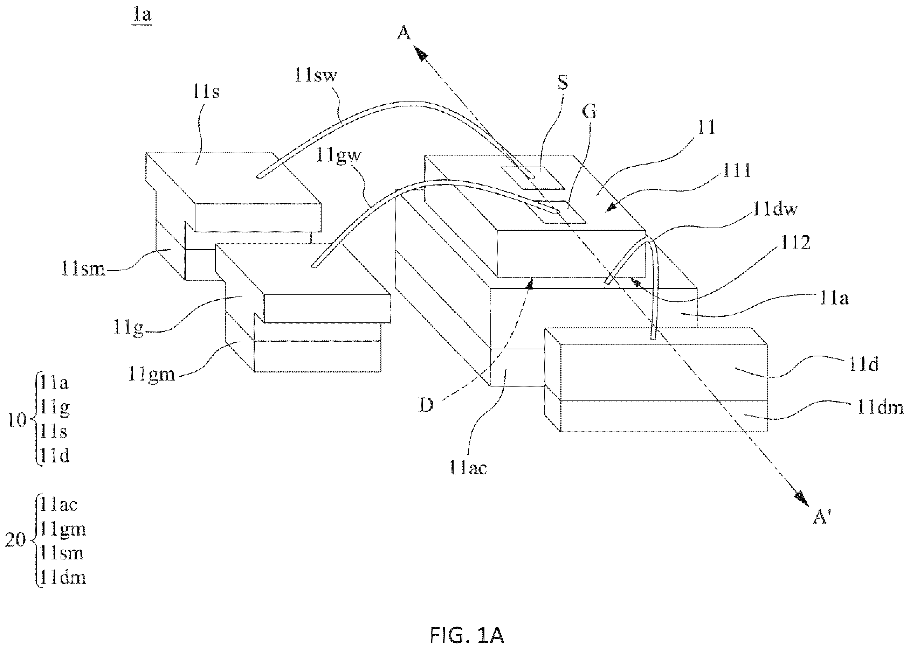

FIG. 1A is a perspective view of a portion of a semiconductor chip package 1a according to embodiments of the present disclosure.

The semiconductor chip package 1a includes a carrier 20, a lead frame 10, and a semiconductor chip 11. The carrier 20, the lead frame 10 and the semiconductor chip 11 are stacked on each other in one direction. The semiconductor chip 11 and the carrier 20 may be disposed on opposing sides of the lead frame 10.

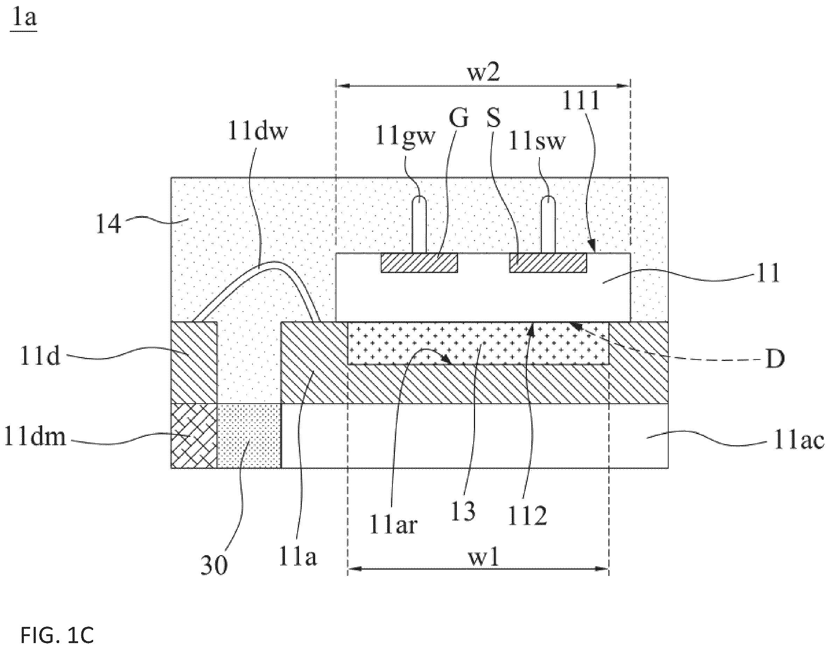

The carrier 20 includes a portion (or referred to as a first portion) 11ac with a relatively high thermal conductivity, and portions 11gm, 11sm and 11dm with a relatively low thermal conductivity (or referred to as a second portion). The portions 11ac, 11gm, 11sm and 11dm are physically separated. The portions 11ac, 11gm, 11sm and 11dm are not directly in contact with each other. The portions 11ac, 11gm, 11sm and 11dm are separated from each other through an insulation layer (e.g., an insulation layer 30 in FIG. 1C).

The portion 11ac overlaps with the semiconductor chip 11. For example, the portion 11ac, a portion of the lead frame 10 (e.g., a chip pad 11a) and the semiconductor chip 11 are stacked on each other in one direction. The portions 11gm, 11sm and 11dm do not overlap with the semiconductor chip 11.

Dimensions (e.g., width, thickness, area, and so on) of the portions 11ac, 11gm, 11sm and 11dm may be the same as or different from each other. The width of the portion 11ac may be greater than the width of the portion 11gm, the portion 11sm or the portion 11dm. Further, the thicknesses of the portions 11ac, 11gm, 11sm and 11dm may be the same as each other.

The portion 11ac may include ceramic materials, e.g., including oxides (such as beryllium oxide (BeO), aluminum oxide (Al₂O₃)), nitride (such as aluminum nitride (AlN), silicon nitride (Si₃N₄)), boride (such as boron nitride (BN)), carbide (such as carbon silicon (SiC)), other ceramic materials (such as diamond (C)), or a combination of two or more thereof. The thermal conductivity of the portion 11ac may be above 100 Wm⁻¹K⁻¹, above 150 Wm⁻¹K⁻¹, above 200 Wm⁻¹K⁻¹ or higher. For example, the portion 11ac may include aluminum nitride (AlN), and may have a thermal conductivity between 170 Wm⁻¹K⁻¹ and 230 Wm⁻¹K⁻¹.

The portion 11ac is configured to conduct heat of the semiconductor chip 11 to the outer environment through a portion of the lead frame 10 (e.g., the chip pad 11a). Compared with an example embodiment that does not use a material having a relatively high thermal conductivity, he thermal conductivity may be increased by at least 10% when using the portion 11ac having a relatively high thermal conductivity, and thus the effect of reducing the device resistance is achieved.

The portions 11gm, 11sm and 11dm may include metallic materials, e.g., including electrically conductive materials such as metals, metal alloys, silicon metals, and so on. Examples of the electrically conductive materials may include gold (Au), silver (Ag), copper (Cu), platinum (Pt), palladium (Pd), tungsten (W), titanium (Ti), tantalum (Ta), molybdenum (Mo), other metals or alloys, or a combination of two or more thereof.

The portions 11gm, 11sm and 11dm may be configured as external terminals for electrical connections between the semiconductor chip package 1a and external devices (e.g., a printed circuit board (PCB), other packages and/or other electrical components).

In some embodiments, the portion 11ac may include a metallic material, such as the materials described above with respect to the portions 11gm, 11sm, and 11sm.

The lead frame 10 may include the chip pad 11a, a gate lead contact 11g, a source lead contact 11s, and a drain lead contact 11d. The chip pad 11a, the gate lead contact 11g, the source lead contact 11s and the drain lead contact 11d may be physically separated. The chip pad 11a, the gate lead contact 11g, the source lead contact 11s and the drain lead contact 11d may not be in direct contact with each other. The chip pad 11a, the gate lead contact 11g, the source lead contact 11s and the drain lead contact 11d may be separated from each other by an encapsulant (e.g., an encapsulant 14 in FIG. 1C).

Dimensions (e.g. width, thickness, area, and so on) of the chip pad 11a, the gate lead contact 11g, the source lead contact 11s and the drain lead contact 11d may be the same as or different from each other. The width of the chip pad 11a may be larger than the width of the gate lead contact 11g, the source lead contact 11s or the drain lead contact 11d. In addition, the thicknesses of the chip pad 11a, the gate lead contact 11g, the source lead contact 11s and the drain lead contact 11d may be the same as each other.

The lead frame 10 may include metallic materials, e.g., including electrically conductive materials such as metals, metal alloys, and so on. Examples of the electrically conductive materials may include gold (Au), silver (Ag), copper (Cu), platinum (Pt), palladium (Pd), other metals or alloys, or two or more combinations thereof.

The chip pad 11a may be configured to carry the semiconductor chip 11. For example, the semiconductor chip 11 may be disposed on the chip pad 11a. The gate lead contact 11g, the source lead contact 11s, and the drain lead contact 11d each may be configured to be coupled to (or electrically connected to) electrical terminals of the semiconductor chip 11. The gate lead contact 11g, the source lead contact 11s and the drain lead contact 11d may each be configured to couple (or electrically connect) the electrical terminals of semiconductor chip 11 to external terminals (e.g., the portions 11gm, 11sm and 11dm of the carrier 20).

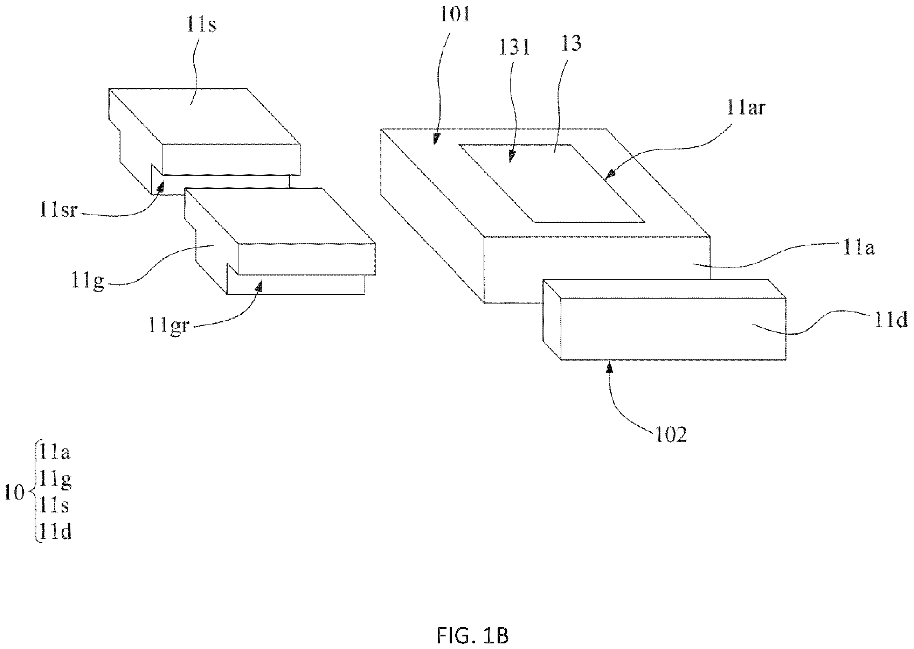

Referring to FIG. 1B, FIG. 1B illustrates the lead frame 10 of the semiconductor chip package 1a in FIG. 1A.

The lead frame 10 has a surface (or a first surface, a first side) 101 and a surface (or a second surface, a second side) 102 opposite to each other. The chip pad 11a of the lead frame 10 has a groove (or a first groove) 11ar recessed from the surface 101. The gate lead contact 11g and the source lead contact 11s of the lead frame 10 may have grooves (or second grooves) 11gr and 11sr recessed from the surface 102 (formed on the surface 102). Although the groove 11ar in FIG. 1B is shown in a shape of a square or rectangle, the shape is not limited in the present disclosure. In some embodiments, the top view of the groove 11ar may be rectangular, circular, hexagonal or any other shape. In some embodiments, the position, shape, ratio of the occupied area, quantity, and so on, of the groove 11ar may be adjusted in order to apply to different packages.

An adhesive 13 is filled in the groove 11ar of the chip pad 11a of the lead frame 10. The adhesive 13 may have a surface 131, which may be generally coplanar with the surface 101 of the lead frame 10. The adhesive 13 may include a conductive adhesive, conductive electrical epoxy, and/or solder.

Referring back to FIG. 1A, when the semiconductor chip 11 is placed on the chip pad 11a, the adhesive 13 as shown in FIG. 1B may be completely covered by the semiconductor chip 11, which prevents the adhesive 13 from overflowing and improves the stability of the lead frame 10, thereby improving the manufacturing yield.

The semiconductor chip 11 may include circuit components such as transistors, resistors, capacitors, and interconnect structures to form an integrated circuit (IC). In some embodiments, the semiconductor chip 11 may include a metal-oxide-semiconductor field-effect transistor (MOSFET), such a NMOS, PMOS, CMOS, a voltage feedback device and/or a switch. In some embodiments, the semiconductor chip 11 may include a double-diffused MOSFET (DMOSFET), an insulated-gate bipolar transistor (IGBT), a junction gate field-effect transistor (JFET), a power bipolar transistor or power diode (e.g., a power Schottky diode).

The semiconductor chip 11 may have a surface 111 and a surface 112 opposite to the surface 111. The surface 112 may contact (e.g., directly contact) an adhesive (e.g., the adhesive 13 in FIG. 1B). The surface 112 may contact (e.g., directly contact) a surface of the lead frame 10 (e.g., the surface 101 in FIG. 1B ), to conduct heat to the portion 11ac of the carrier 20.

One or more electrical terminals may be exposed from the surface 111 and/or the surface 112 of the semiconductor chip 11. For example, the gate G and source S of the semiconductor chip 11 may be located on the same side of the semiconductor chip 11, and the drain D of the semiconductor chip 11may be located on the opposite side. The gate G and source S of the semiconductor chip 11 may be located on the surface 111, and the drain D may be located on the surface 112.

The gate G of the semiconductor chip 11 may be coupled (or electrically connected) to the gate lead contact 11g of the lead frame 10 through a wire 11gw. The gate lead contact 11g may be configured to couple (or electrically connect) the gate G of the semiconductor chip 11 to an external terminal (e.g., the portion 11gm of the carrier 20).

The source S of the semiconductor chip 11 may be coupled (or electrically connected) to the source lead contact 11s of the lead frame 10 through a wire 11sw. The source lead contact 11s may be configured to couple (or electrically connect) the source S of the semiconductor chip 11 to an external terminal (e.g., the portion 11sm of the carrier 20).

The drain D of the semiconductor chip 11 may be coupled (or electrically connected) to the adhesive 13. The drain D of the semiconductor chip 11 may be coupled (or electrically connected) to the drain lead contact 11d of the lead frame 10 through the adhesive 13, the chip pad 11a and a wire 11dw. The drain lead contact 11d may be configured to couple (or electrically connect) the drain D of the semiconductor chip 11 to an external terminal (e.g., the portion 11dm of the carrier 20).

In some embodiments, the wire11gw, the wire 11sw, and the wire 11dw may be replaced by copper strips or copper sheets, and may connect the electrical terminals of the semiconductor chip 11 to the lead frame 10 using copper clip bond.

In some embodiments, in order to increase the thermal conductivity, a non-electrically conductive ceramic material may be used for the portion 11ac. Because the chip pad 11a is carried on the portion 11ac, the portion 11ac may not be electrically conductive, and thus the wire 11dw and the drain lead contact 11d are needed to couple (or electrically connect) the drain D of the semiconductor chip 11 to an external terminal (e.g., the portion 11dm of the carrier 20). In some embodiments, an electrically conductive metal material may be used for the portion 11ac to provide an optimal conductivity path for the drain D.

FIG. 1C is a cross-sectional view of the semiconductor chip package 1a according to embodiments of the present disclosure. In some embodiments, FIG. 1C is a cross-sectional view of the semiconductor chip package 1a in FIG. 1A along a line AA'. The same or similar components are referenced with the same symbols, and the detailed description of the same or similar components will not be repeated again.

In addition to the carrier 20, the lead frame 10 and the semiconductor chip 11, the semiconductor chip package 1a also includes the encapsulant 14 and the insulation layer 30. In order to clearly show the relationship between the components, the encapsulant 14 and the insulation layer 30 are omitted from the perspective view of FIG. 1A. The cross-sectional view in FIG. 1C omits the portions 11gm and 11sm of the carrier 20, and the gate lead contact 11g and the source lead contact 11s of the lead frame 10.

The insulation layer 30 may be filled in the carrier 20. For example, the insulation layer 30 may be filled in between any two portions of the portion 11ac, the portion 11gm, the portion 11sm and the portion 11dm of the carrier 20. The insulation layer 30 may contact a portion of the encapsulant 14.

The encapsulant 14 covers the semiconductor chip 11.
Referring to FIG. 1B, the encapsulant 14 may contact, cover or encapsulate the chip pad 11a, the gate lead contact 11g, the source lead contact 11s and the drain lead contact 11d of the lead frame 10. The encapsulant 14 may contact, cover, or encapsulate the surface 101 of the lead frame 10. The encapsulant 14 may not be in contact with the adhesive 13. The encapsulant 14 may be filled in the groove 11gr and the groove 11sr to improve the structural stability of the lead frame 10.

The insulation layer 30 and encapsulant 14 may each include insulating or dielectric materials. Examples of the insulating materials may include epoxy resin with filler, a molding material or molding compound, polyimide, a phenolic compound, a material containing silicone, or any combination thereof. Examples of the dielectric materials may include silicon oxide (SiO2), silicon nitride (Si₃N₄), silicon oxynitride (Si₂N₂O), borophosphosilicate glass (BPSG), phosphosilicate glass (PSG), undoped silicon glass (USG), fluorosilicate glass (FSG), spin-on glass (SOG), or a combination of any two or more thereof. The insulation layer 30 and the encapsulant 14 may include the same material. The insulation layer 30 and the encapsulant 14 may include different materials.

In some embodiments, the insulation layer 30 may use a ceramic material to reduce the coefficient of thermal expansion (CTE) between the carrier 20 (which may contain a metal material) and the encapsulants 14 (which may contain an insulation material) and improve thermal conductivity.

As described above, the adhesive 13 is filled in the groove 11ar of the chip pad 11a of the lead frame 10 and may be completely covered by the semiconductor chip 11. The width w1 of the adhesive 13 or the groove 11ar may be no larger than the width w2 of the semiconductor chip 11. The width w1 of the adhesive 13 or the groove 11ar may be generally equal to the width w2 of the semiconductor chip 11. The width w1 of the adhesive 13 or the groove 11ar may be smaller than the width w2 of the semiconductor chip 11.

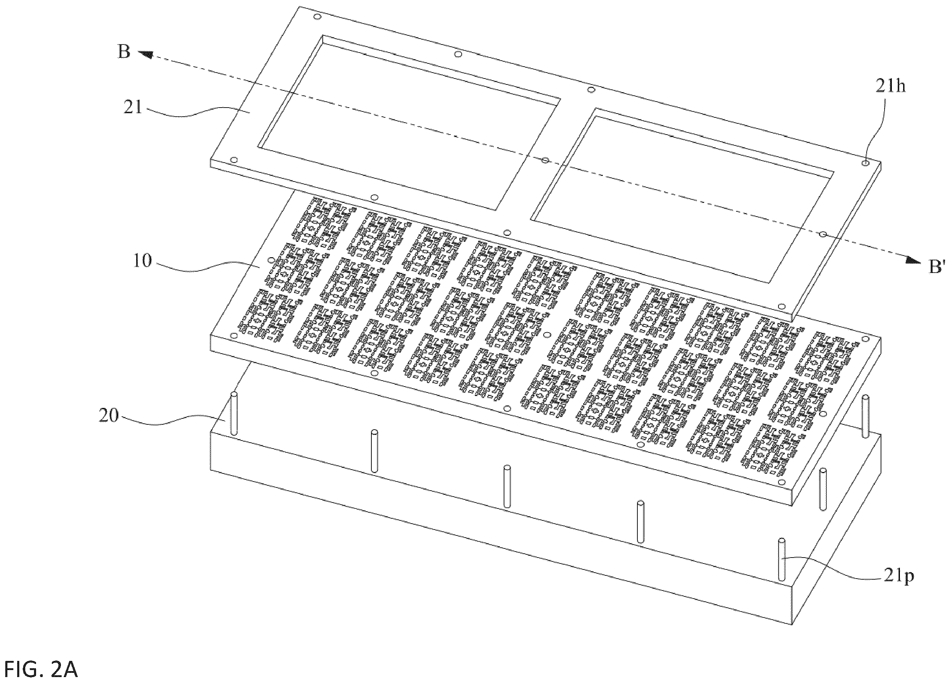

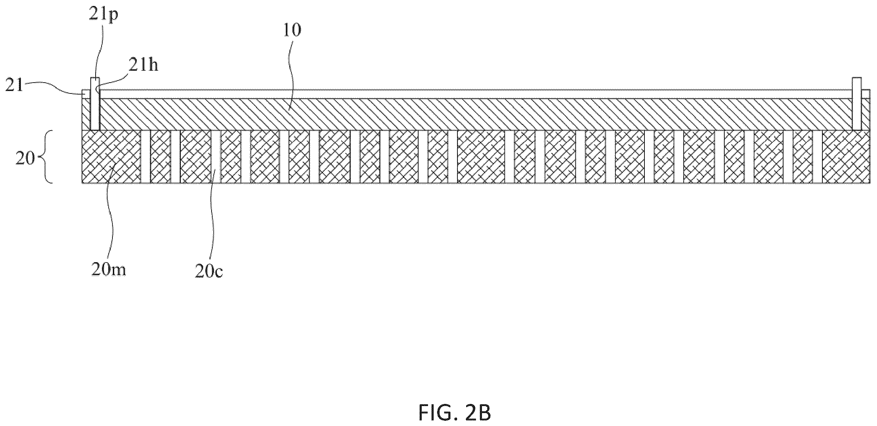

FIG. 2A and FIG. 2B illustrate one or more example stages in a manufacturing method of a semiconductor chip package according to some embodiments of the present disclosure. In some embodiments, FIG. 2B is a cross-sectional view of the structure in FIG. 2A along a line BB'. At least some of the figures has been simplified in order to facilitate understanding of aspects of the present disclosure.

Referring to FIG. 2A, the manufacturing method includes obtaining a lead frame 10, and may include affixing the lead frame 10 on a carrier 20 using a clamping device 21, such that the lead frame 10 is clamped between the clamping device 21 and the carrier 20. The clamping device 21 and the carrier 20 are arranged on the opposite sides of the lead frame 10. The clamping device 21 and the lead frame 10 may together be provided with a plurality of through-holes 21h. Fastening bolts 21p may be passed through the through-holes 21h such that the clamping device 21 and the lead frame 10 are affixed to the carrier 20.

The clamping device 21 may have two openings for exposing a device area of the lead frame 10. The position, shape, ratio of occupied area, quantity, and so on, of the openings may be adjusted in order to be applied to different packages, and are not limited to the aspects depicted in FIG. 2A.

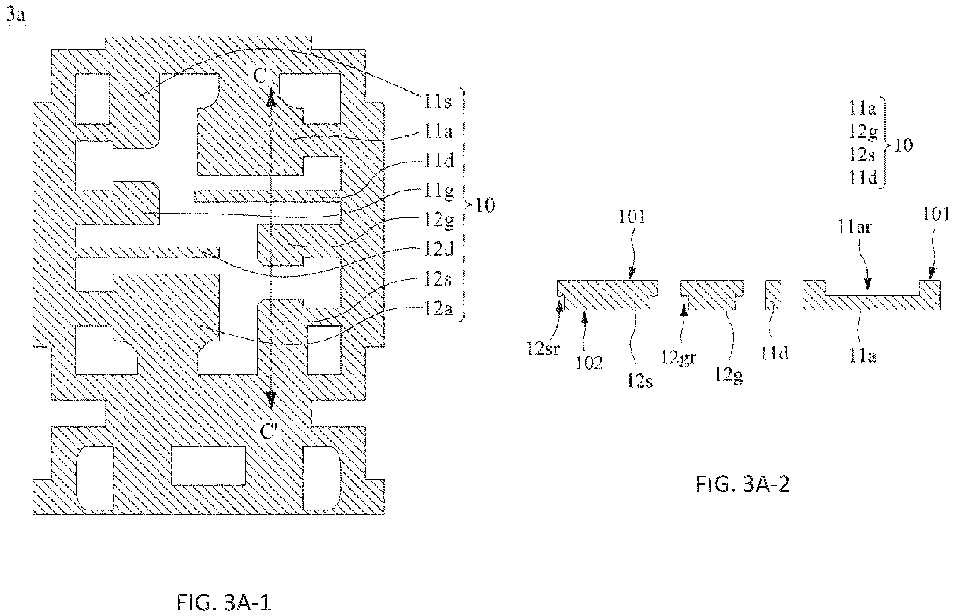

The lead frame 10 may include the device area exposed from the clamping device 21, and an edge area provided with the through holes 21h. The edge area surrounds the device area. The device area may include a plurality of units, and a unit may be segregated from another unit through a single cut. The semiconductor chip package 1a as described with respect to FIG. 1A, FIG. 1B, and FIG. 1C may include one unit. A lead frame area 3a in FIG. 3A-1 may include two units.

Referring to FIG. 2B, the carrier 20 includes portions (or first portions) 20c having a relatively high thermal conductivity and portions (or second portions) 20m having a relatively low thermal conductivity. The portions 20c may include a ceramic material, such as the materials described above with respect to the portion 11ac. The portions 20m may include a metal material, such as the materials described with respect to the portion 11gm, the portion 11sm and the portion 11dm. The portions 20c may be arranged in between the portions 20m. In some embodiments, the positions of the portions 20c may correspond to the chip pad of the lead frame 10 for bearing a semiconductor chip.

FIGs. 3A-1, 3A-2, 3B, 3C, 3D-1, 3D-2, 3E-1, 3E-2, 3F, 3G, and 3H illustrate one or more example stages in a manufacturing method of a semiconductor chip package according to some embodiments of the present disclosure. At least some of the figures have been simplified for better understanding of aspects of the present disclosure. For the sake of brevity, the following figures illustrate a manufacturing process on a lead frame area 3a of a lead frame 10, which may include two units. A similar manufacturing process may be used for other areas of the lead frame 10.

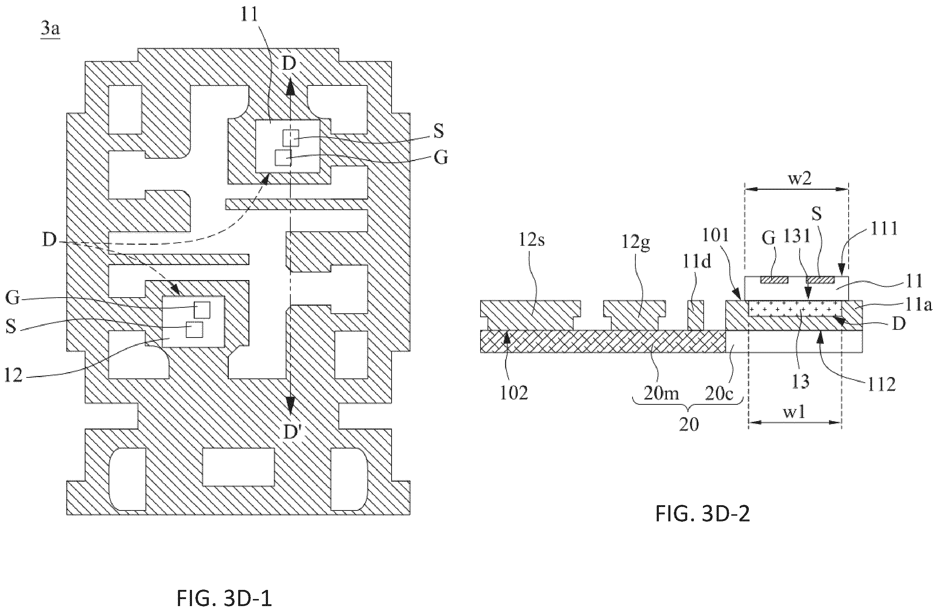

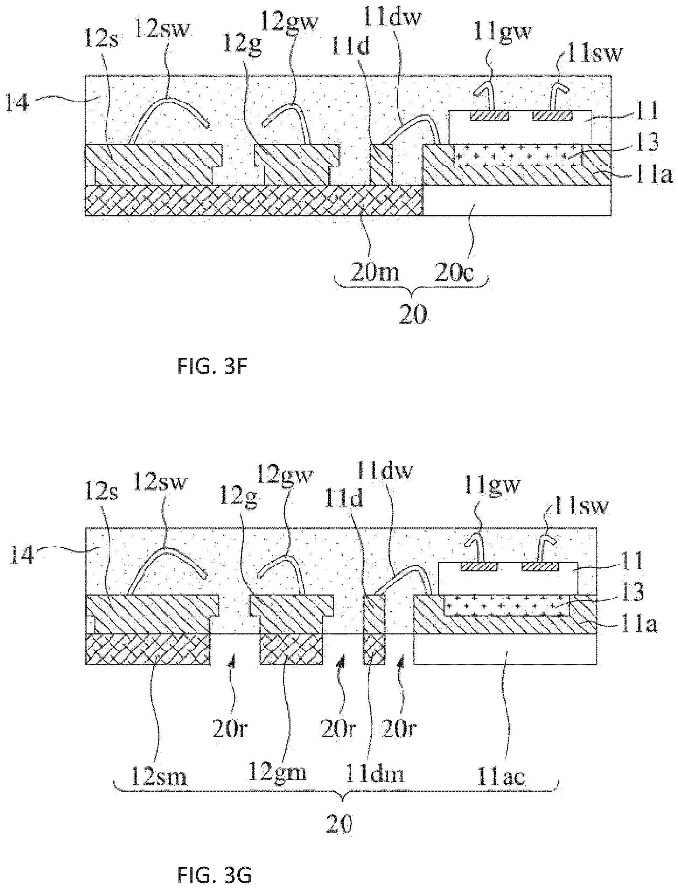

Referring to FIG. 3A-1 and FIG. 3A-2, in some embodiments, FIG. 3A-2 is a cross-sectional view of the lead frame area 3a of the lead frame 10 in FIG. 3A-1 along a line CC'. The manufacturing method includes obtaining the lead frame 10. The lead frame 10 may include, before being cut for singulation, interconnected chip pads 11a and 12a, gate lead contacts 11g and 12g, source lead contacts 11s and 12s, and drain lead contacts 11d and 12d. The chip pad 12a may be configured to carry another semiconductor chip (e.g., a semiconductor chip 12 in FIG. 3D-1). The gate lead contact 12g, the source lead contact 12s and the drain lead contact 12d each may be configured to couple (or electrically connect) to electrical terminals of the another semiconductor chip previously mentioned. The gate lead contact 12g, the source lead contact 12s and the drain lead contact 12d may each be configured to couple (or electrically connect) the electrical terminals of the another semiconductor chip to external terminals (e.g., portions 12gm and 12sm of a carrier 20 in FIG. 3G). As shown in FIG. 3A-2, the chip pad 11a of the lead frame 10 may have a groove 11ar recessed from a surface 101 of the lead frame 10. The gate lead contact 12g and the source lead contact 12s of the lead frame 10 may have respective grooves 12gr and 12sr recessed from a surface 102.

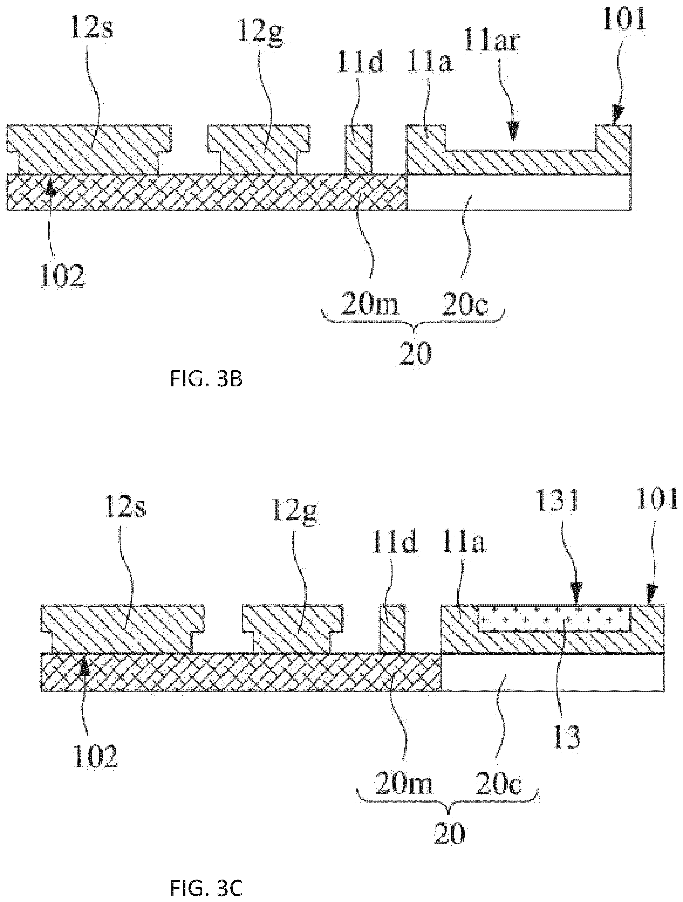

Referring to FIG. 3B, the manufacturing method includes disposing a carrier 20 on the surface 102 of the lead frame 10. The position of a portion 20c of the carrier 20 may correspond to the chip pad 11a of the lead frame 10. In some embodiments, the manufacturing method may include passing fastening bolts (for example, the fastening bolts 21p as described with respect to FIG. 2A) through through-holes of the lead frame 10 (for example, the through-holes 21h in FIG. 2A). In some embodiments, the manufacturing method may include using a clamp (e.g., the clamping device 21 in FIG. 2A ) to affix the lead frame 10 on the carrier 20.

Referring to FIG. 3C, the manufacturing method includes filling an adhesive 13 in the groove 11ar. In some embodiments, the adhesive 13 may be formed through screen printing or dispensing. The adhesive 13 may have a surface 131 that is generally coplanar with the surface 101 of the lead frame 10.

Referring to FIG. 3D-1 and FIG. 3D-2, in some embodiments, FIG. 3D-2 is a cross-sectional view of the lead frame area 3a of the lead frame 10 in FIG. 3D-1 along a line DD'. The manufacturing method includes arranging a semiconductor chip 11 on the surface 101 of the lead frame 10 and the adhesive 13. In some embodiments, the manufacturing method may further include providing a semiconductor chip 12. The gate G and source S of the semiconductor chip 12 may be located at the same side of the semiconductor chip 12, and the drain D of the semiconductor chip 12 may be located on the opposing side. For detailed description of the semiconductor chip 12, reference may be made to that of the semiconductor chip 11, and the description will not be repeated here. As shown in FIG. 3D-2, the adhesive 13 may be completely covered by the semiconductor chip 11. The width w1 of the adhesive 13 or the groove 11ar may be no larger than the width w2 of the semiconductor chip 11. The width w1 of the adhesive 13 or the groove 11ar may be generally equal to the width w2 of the semiconductor chip 11. The width w1 of the adhesive 13 or the groove 11ar may be smaller than the width w2 of the semiconductor chip 11.

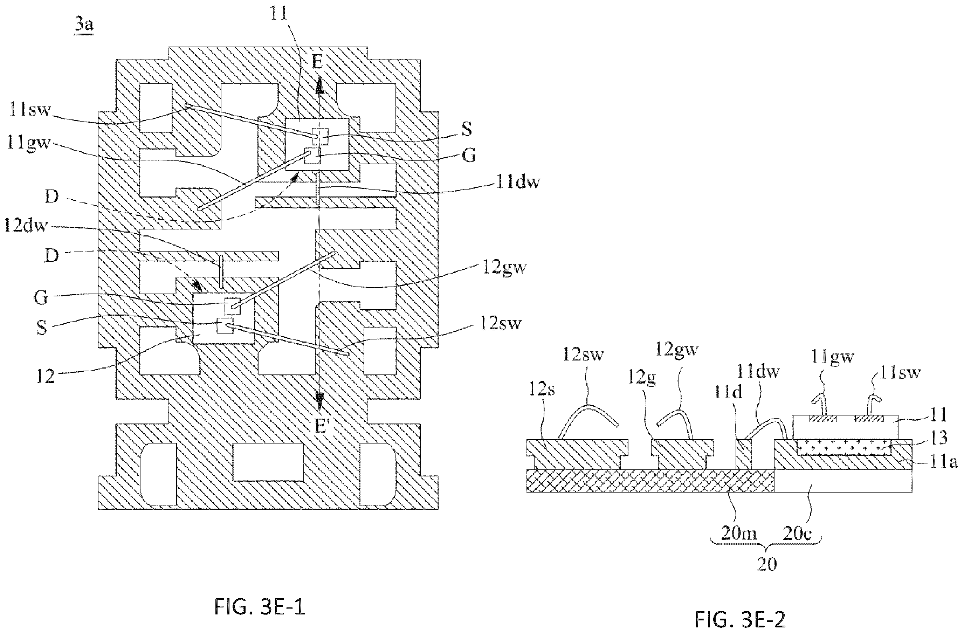

Referring to FIG. 3E-1 and FIG. 3E-2, in some embodiments, FIG. 3E-2 is a cross-sectional view of the lead frame area 3a of the lead frame 10 in FIG. 3E-1 along a line EE'. The manufacturing method may include forming wires to couple (or electrically connect) the electrical terminals of the semiconductors chip 11. For example, the gate G of the semiconductor chip 11 may be coupled (or electrically connected) to the gate lead contact 11g of the lead frame 10 via the wire 11gw. The source S of the semiconductor chip 11 may be coupled (or electrically connected) to the source lead contact 11s of the lead frame 10 via the wire 11sw. The drain D of the semiconductor chip 11 may be coupled (or electrically connected) to the drain lead contact 11d of the lead frame 10 via the adhesive 13, the chip pad 11a and the wire 11dw.

In some embodiments, the manufacturing method may further include forming wires to couple (or electrically connect) electrical terminals of the semiconductor chip12. For example, the gate G of the semiconductor chip 12 may be coupled (or electrically connected) to the gate lead contact 12g of the lead frame 10 via the wire 12gw. The source S of the semiconductor chip 12 may be coupled (or electrically connected) to the source lead contact 12s of the lead frame 10 via the wire 12sw. The drain D of the semiconductor chip 12 may be coupled (or electrically connected) to the drain lead contact 12d of the lead frame 10 via adhesive, the chip pad 12a and the wire 12dw.

Referring to FIG. 3F, the manufacturing method includes covering, with an encapsulant 14, the lead frame 10, the semiconductor chip 11 and possibly other semiconductor chips (e.g., the semiconductor chip 12 in FIG. 3E-1). The encapsulant 14 may be filled in grooves recessed from the surface 102, e.g., the groove 12gr and the groove 12sr in FIG. 3A-2, and the groove 11gr and the groove 11sr in FIG. 1A. In some embodiments, the encapsulant 14 may be formed by molding, e.g., formed by printing, compression molding, transfer molding, liquid encapsulant molding, vacuum lamination, spin coating, or other applicable processes.

Referring to FIG. 3G, the manufacturing method includes removing portion(s) of the carrier 20 to form groove(s) 20r. In some embodiments, the manufacturing method may include removing a portion of the carrier 20 that has a relatively low thermal conductivity (or a metal portion, e.g., the portion 20m in FIG. 3B), such that portions with a relatively high thermal conductivity (or ceramic portions, e.g., the portion 20c in FIG. 3B) are not in contact with portions with a relatively low thermal conductivity. As shown in FIG. 3G, the portion with the relatively high thermal conductivity (or ceramic portion, e.g., the portion 20c in FIG. 3B) is separated from the other portions of the carrier 20 to form the portion 11ac. In some embodiments, the width of the portion 11ac may be generally the same as the width of the chip pad 11a.

The portions with the relatively low thermal conductivity (or metal portions, e.g., the portion 20m in FIG. 3B) are separated from each other to form the portion 11dm, the portion 12gm and the portion 12sm. The portion 11dm and the portion 11ac are a portion of the semiconductor chip package 1a in FIG. 1A. The portion 12gm and the portion 12sm are a portion of a package of another semiconductor chip (e.g., the semiconductor chip 12 in FIG. 3E-1).

In some embodiments, the groove(s) 20r may be formed using a laser drilling process. In some embodiments, the groove(s) 20r may expose a portion of the encapsulant 14. In some embodiments, a groove 20r may have a width that generally does not change. In some embodiments, the groove(s) 20r may have different slopes, may be gradually wider toward the encapsulant 14, or may be gradually narrower toward the encapsulant 14.

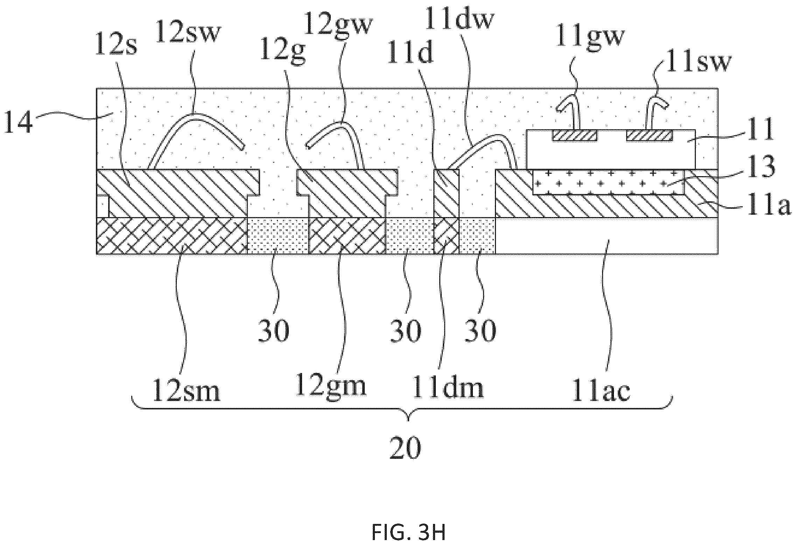

Referring to FIG. 3H, the manufacturing method may include filling the groove 20r with an insulation layer 30. The insulation layer 30 may be formed using atomic layer deposition (ALD), chemical vapor deposition (CVD) or other deposition processes. In some embodiments, a grinding process, such as chemical mechanical polishing (CMP), may be performed to grind and remove a portion of the insulation layer 30 that is outside the groove 20r.

In some embodiments, the manufacturing method may include performing singulation to separate individual structures. This may be done by using, e.g., a dicing saw, laser, or other appropriate cutting technologies. The semiconductor structure formed using the above steps may be the same as the semiconductor chip package 1a shown in FIG. 1A.

FIG. 4A is a perspective view of a portion of a semiconductor chip package 4a according to embodiments of the present disclosure. The semiconductor chip package 4a is similar to the semiconductor chip package 1a as described with respect to FIG. 1A, except that the gate G, source S and drain D of the semiconductor chip 11 of the semiconductor chip package 4a are located at the same side, such as the surface 111. The drain D may be coupled (or electrically connected) to the drain lead contact 11d of the lead frame 10 via the wire 11dw.

FIG. 4B illustrates one or more stages in a manufacturing method of a semiconductor chip package according to embodiments of the present disclosure. FIG. 4B is similar to FIG. 3E-1, except that the gate G, source S and drain D of the semiconductor chip 12 in FIG. 4B are located at the same side. The drain D may be coupled (or electrically connected) to the drain lead contact 11d of the lead frame 10 via a copper strip 12dp. The source S may be coupled (or electrically connected) to the source lead contact 12s of the lead frame 10 via a copper strip 12sp.

In this disclosure, for description convenience, spatially relative terms such as "below", "under", "lower", "above", "upper", "left side", "right side", and so on, may be used to describe the relationship of one component or feature with another one or more components or features, as shown in the accompanying drawings. The spatially relative terms are not only used to depict the orientations in the accompanying drawings, but also intended to encompass different orientations of a device in use or operation. A device may be oriented in other ways (rotated 90 degrees or in other orientations), and the spatially relative terms used herein may be interpreted in a corresponding way similarly. It should be understood that when a component is referred to as being "connected to" or "coupled to" another component, it can be directly connected or coupled to another component or an intervening component may be present.

As used herein, the terms "approximately", "basically", "substantially" and "about" are used to describe and account for small variations. When used in conjunction with an event or instance, the terms may refer to an embodiment of exact occurrence of an event or instance as well as an embodiment where the event or instance is close to the occurrence. As used herein with respect to a given value or range, the term "about" generally means being within ±10%, ±5%, ±1%, or ±0.5% of the given value or range. A range herein may be referred to as being from one endpoint to the other or as being between two endpoints. All ranges disclosed herein are inclusive of the endpoints unless otherwise indicated. The term "generally coplanar" may mean that the difference of positions of two surfaces with reference to the same plane is within a few micrometers (µm), e.g., within 10 µm, within 5 µm, within 1 µm, or within 0.5 µm. When values or characteristics are referred to as being "generally" the same, the term may refer to a value that is within ±10%, ±5%, ±1%, or ±0.5% of the mean of the values.

The foregoing has outlined features of some embodiments and detailed aspects of present disclosure. The embodiments described in the present disclosure may be readily used as a basis for designing or modifying other processes and structures in order to carry out the same or similar purposes and/or to achieve the same or similar advantages of the embodiments presented herein. The scope of the invention is defined by the claims.

## Claims

1. A semiconductor chip package (1a), comprising:
a lead frame (10) having a first surface (101) and a second surface (102) opposite to each other, the lead frame having a first groove (11ar) recessed from the first surface of the lead frame;
an adhesive (13) filled in the first groove (11ar); and
a semiconductor chip (11) disposed on the first surface (101) of the lead frame and on the adhesive (13);
an encapsulant (14) disposed on the first surface of the lead frame and covering the semiconductor chip; **characterized in** further comprising:
a carrier (20) disposed on the second surface of the lead frame, wherein the carrier has a first portion (11ac) and a second portion (11gm, 11sm and 11dm) separated from each other through an insulation layer (30), wherein a thermal conductivity coefficient of the first portion being greater than a thermal conductivity coefficient of the second portion, wherein the first portion of the carrier overlaps with the semiconductor chip, and the second portion of the carrier does not overlap with the semiconductor chip, wherein the insulation layer contacts a portion of the encapsulant, and wherein the first portion comprises a ceramic portion and the thermal conductivity coefficient of the first portion is above 100 Wm⁻¹K⁻¹.

2. The semiconductor chip package of claim 1, wherein the adhesive (13) is completely covered by the semiconductor chip (11); or wherein the adhesive has a surface that is substantially coplanar with the first surface (101) of the lead frame.

3. The semiconductor chip package of claim 1, wherein the lead frame has a second groove (11gr) recessed from the second surface of the lead frame, and the encapsulant fills in the second groove.

4. The semiconductor chip package of claim 3, wherein the lead frame comprises a chip pad (11a), a gate lead contact (11g), a source lead contact (11s), and a drain lead contact (11d) which are physically separated from one another, and wherein the gate lead contact (11g) comprises the second groove.

5. The semiconductor chip package of claim 1, wherein the lead frame has a chip pad (11a) for carrying the semiconductor chip and a drain lead contact (11d) physically separated from the chip pad.

6. The semiconductor chip package of claim 5, wherein the semiconductor chip has a gate (G), a source (S) and a drain (D), the drain is located on one side of the semiconductor chip, the gate and the source are located on an opposite side of the semiconductor chip, and the drain is coupled to the drain lead contact (11d) through the adhesive (13), the chip pad (11a), and a wire (11dw).

7. The semiconductor chip package of claim 1, wherein the second portion comprises a metal portion.

8. The semiconductor chip package of claim 1, wherein the second portion of the carrier comprises a first external terminal (11sm), a second external terminal (11gm), and a third external terminal (11dm) of the semiconductor chip package.

9. The semiconductor chip package of claim 6, wherein the drain lead contact (11d) is configured to couple the drain of the semiconductor chip (11) to an external terminal (11dm) included within the carrier (20).

10. The semiconductor chip package of any preceding claim, wherein a width (w1) of the first groove is not greater than a width (w2) of the semiconductor chip.

11. A manufacturing method of a semiconductor chip package (1a), comprising:
obtaining a lead frame (10) having a first surface (101) and a second surface (102) opposite to each other, the lead frame having a first groove (11ar) recessed from the first surface of the lead frame;
filling the first groove (11ar) with an adhesive (13); and
disposing a semiconductor chip (11) on the first surface (101) of the lead frame and on the adhesive (13);
covering the lead frame (10) and the semiconductor chip (11) with an encapsulant (14); **characterized in that** the method further comprises:
disposing a carrier (20) on the second surface (102) of the lead frame (10), wherein the carrier has a first portion (20c) and a second portion (20m) separated from each other through an insulation layer (30), wherein a thermal conductivity coefficient of the first portion being greater than a thermal conductivity coefficient of the second portion, wherein the first portion of the carrier overlaps with the semiconductor chip, and the second portion of the carrier does not overlap with the semiconductor chip, wherein the insulation layer contacts a portion of the encapsulant, and wherein the first portion comprises a ceramic portion and the thermal conductivity coefficient of the first portion is above 100 Wm⁻¹K⁻¹.

12. The manufacturing method of claim 11, further comprising:
fixing the lead frame on the carrier by using a clamp (21).

13. The manufacturing method of claim 12, wherein the manufacturing method further comprises:
after disposing the carrier (20) on the second surface (102) of the lead frame (10), removing a portion of the second portion (20m) of the carrier such that the second portion does not contact the first portion (20c).

14. The manufacturing method of claim 13, wherein:
removing the portion of the second portion (20m) of the carrier comprises: forming the second portion into a first external terminal (12sm), a second external terminal (12gm) and a third external terminal (11dm) that are separated from each other.

15. The manufacturing method of claim 11, further comprising:
coupling a drain of the semiconductor chip to a drain lead contact of the lead frame through a wire,
wherein the encapsulant is filled in a second groove (11gr) recessed from the second surface (102) of the lead frame (10).

## Patentansprüche

1. Halbleiterchip-Package (1a), umfassend:
einen Anschlussrahmen (10), der eine erste Oberfläche (101) und eine zweite Oberfläche (102) einander gegenüberliegend aufweist, wobei der Anschlussrahmen eine erste Nut (11ar) aufweist, die von der ersten Oberfläche des Anschlussrahmens vertieft ist;
einen Klebstoff (13), der die erste Nut (11ar) ausfüllt; und
einen Halbleiterchip (11), der auf der ersten Oberfläche (101) des Anschlussrahmens und auf dem Klebstoff (13) angeordnet ist;
ein Verkapselungsmaterial (14), das auf der ersten Oberfläche des Anschlussrahmens angeordnet ist und den Halbleiterchip bedeckt; **dadurch gekennzeichnet, dass** es weiter Folgendes umfasst:
einen Träger (20), der auf der zweiten Oberfläche des Anschlussrahmens angeordnet ist, wobei der Träger weist einen ersten Abschnitt (11ac) und einen zweiten Abschnitt (11gm, 11sm und 11dm) aufweist, die durch eine Isolierschicht (30) voneinander getrennt sind, wobei ein Wärmeleitfähigkeitskoeffizient des ersten Abschnitts größer ist als ein Wärmeleitfähigkeitskoeffizient des zweiten Abschnitts, wobei der erste Abschnitt des Trägers den Halbleiterchip überlappt und der zweite Abschnitt des Trägers den Halbleiterchip nicht überlappe, wobei die Isolierschicht einen Abschnitt des Verkapselungsmaterials kontaktiert, und wobei der erste Abschnitt einen Keramikabschnitt umfasst und der Wärmeleitfähigkeitskoeffizient des ersten Abschnitts über 100 Wm⁻¹K⁻¹ liegt.

2. Halbleiterchip-Gehäuse nach Anspruch 1, wobei der Klebstoff (13) vollständig vom Halbleiterchip (11) bedeckt ist; oder wobei der Klebstoff eine Oberfläche aufweist, die im Wesentlichen komplanar mit der ersten Oberfläche (101) des Anschlussrahmens ist.

3. Halbleiterchip-Gehäuse nach Anspruch 1, wobei der Anschlussrahmen eine zweite Nut (11gr) aufweist, die von der zweiten Oberfläche des Anschlussrahmens vertieft ist, und das Verkapselungsmaterial die zweite Nut ausfüllt.

4. Halbleiterchip-Gehäuse nach Anspruch 3, wobei der Anschlussrahmen ein Chip-Pad (11a), einen Gate-Anschlusskontakt (11g), einen Source-Anschlusskontakt (11s) und einen Drain-Anschlusskontakt (11d) umfasst, die physisch voneinander getrennt sind, und wobei der Gate-Anschlusskontakt (11g) die zweite Nut umfasst.

5. Halbleiterchip-Package nach Anspruch 1, wobei der Anschlussrahmen ein Chip-Pad (11a) zum Aufnehmen des Halbleiterchips und einen Drain-Anschlusskontakt (11d), der physisch vom Chip-Pad getrennt ist, aufweist.

6. Halbleiterchip-Package nach Anspruch 5, wobei der Halbleiterchip ein Gate (G), eine Source (S) und einen Drain (D) aufweist, der Drain sich auf einer Seite des Halbleiterchips befindet, das Gate und die Source sich auf einer gegenüberliegenden Seite des Halbleiterchips befinden und der Drain über den Klebstoff (13), das Chip-Pad (11a) und einen Draht (11dw) mit dem Drain-Anschlusskontakt (11d) gekoppelt ist.

7. Halbleiterchip-Package nach Anspruch 1, wobei der zweite Abschnitt einen Metallabschnitt umfasst.

8. Halbleiterchip-Package nach Anspruch 1, wobei der zweite Abschnitt des Trägers eine erste externe Anschlussklemme (11sm), eine zweite externe Anschlussklemme (11gm) und eine dritte externe Anschlussklemme (11dm) des Halbleiterchip-Packages umfasst.

9. Halbleiterchip-Package nach Anspruch 6, wobei der Drain-Anschlusskontakt (11d) dazu konfiguriert ist, den Drain des Halbleiterchips (11) mit einer externen Anschlussklemme (11dm) zu koppeln, die in dem Träger (20) beinhaltet ist.

10. Halbleiterchip-Package nach einem vorstehenden Anspruch, wobei eine Breite (w1) der ersten Nut nicht größer ist als eine Breite (w2) des Halbleiterchips.

11. Herstellungsverfahren für ein Halbleiterchip-Package (1a), umfassend:
Erhalten eines Anschlussrahmens (10), der eine erste Oberfläche (101) und eine zweite Oberfläche (102) einander gegenüberliegend aufweist, wobei der Anschlussrahmen eine erste Nut (11ar) aufweist, die von der ersten Oberfläche des Anschlussrahmens vertieft ist;
Füllen der ersten Nut (11ar) mit einem Klebstoff (13); und
Anordnen eines Halbleiterchips (11) auf der ersten Oberfläche (101) des Anschlussrahmens und auf dem Klebstoff (13);
Bedecken des Anschlussrahmens (10) und des Halbleiterchips (11) mit einem Verkapselungsmaterial (14);
**dadurch gekennzeichnet, dass** das Verfahren weiter Folgendes umfasst:
Anordnen eines Trägers (20) auf der zweiten Oberfläche (102) des Anschlussrahmens (10), wobei der Träger weist einen ersten Abschnitt (20c) und einen zweiten Abschnitt (20m) aufweist, die durch eine Isolierschicht (30) voneinander getrennt sind, wobei ein Wärmeleitfähigkeitskoeffizient des ersten Abschnitts größer ist als ein Wärmeleitfähigkeitskoeffizient des zweiten Abschnitts, wobei der erste Abschnitt des Trägers den Halbleiterchip überlappt und der zweite Abschnitt des Trägers den Halbleiterchip nicht überlappe, wobei die Isolierschicht einen Abschnitt des Verkapselungsmaterials kontaktiert, und wobei der erste Abschnitt einen Keramikabschnitt umfasst und der Wärmeleitfähigkeitskoeffizient des ersten Abschnitts über 100 Wm⁻¹K⁻¹ liegt.

12. Herstellungsverfahren nach Anspruch 11, weiter umfassend:
Befestigen des Anschlussrahmens am Träger unter Verwendung einer Klemme (21).

13. Herstellungsverfahren nach Anspruch 12, wobei das Herstellungsverfahren weiter Folgendes umfasst:
nach Anordnen des Trägers (20) auf der zweiten Oberfläche (102) des Anschlussrahmens (10), Entfernen eines Abschnitts des zweiten Abschnitts (20m) des Trägers, sodass der zweite Abschnitt den ersten Abschnitt (20c) nicht kontaktiert.

14. Herstellungsverfahren nach Anspruch 13, wobei:
Entfernen des Abschnitts des zweiten Abschnitts (20m) des Trägers umfasst: Bilden des zweiten Abschnitts in eine erste externe Anschlussklemme (12sm), eine zweite externe Anschlussklemme (12gm) und eine dritte externe Anschlussklemme (11dm), die voneinander getrennt sind.

15. Herstellungsverfahren nach Anspruch 11, weiter umfassend:
Koppeln des Drains des Halbleiterchips mit einem Drain-Anschlusskontakt des Anschlussrahmens über einen Draht,
wobei das Verkapselungsmaterial eine zweite Nut (11gr) ausfüllt, die von der zweiten Oberfläche (102) des Anschlussrahmens (10) vertieft ist.

## Revendications

1. Boîtier de puce semi-conductrice (1a), comprenant :
un cadre de montage (10) présentant une première surface (101) et une seconde surface (102) opposées l'une à l'autre, le cadre de montage présentant une première rainure (11ar) en retrait par rapport à la première surface du cadre de montage ;
un adhésif (13) remplissant la première rainure (11ar) ; et
une puce semi-conductrice (11) disposée sur la première surface (101) du cadre de montage et sur l'adhésif (13) ;
un encapsulant (14) disposé sur la première surface du cadre de montage et recouvrant la puce semi-conductrice ; **caractérisé en ce qu'**il comprend en outre :
un support (20) disposé sur la seconde surface du cadre de montage, dans lequel le support présente une première partie (11ac) et une seconde partie (11gm, 11sm et 11dm) séparées l'une de l'autre par le biais d'une couche isolante (30), dans lequel un coefficient de conductivité thermique de la première partie est supérieur à un coefficient de conductivité thermique de la seconde partie, dans lequel la première partie du support chevauche la puce semi-conductrice et la seconde partie du support ne chevauche pas la puce semi-conductrice, dans lequel la couche isolante est en contact avec une partie de l'encapsulant, et dans lequel la première partie comprend une partie en céramique et le coefficient de conductivité thermique de la première partie est supérieur à 100 Wm⁻¹K⁻¹.

2. Boîtier de puce semi-conductrice selon la revendication 1, dans lequel l'adhésif (13) est entièrement recouvert par la puce semi-conductrice (11) ; ou dans lequel l'adhésif présente une surface qui est sensiblement coplanaire avec la première surface (101) du cadre de montage.

3. Boîtier de puce semi-conductrice selon la revendication 1, dans lequel le cadre de montage présente une seconde rainure (11gr) en retrait par rapport à la seconde surface du cadre de montage, et l'encapsulant remplit la seconde rainure.

4. Boîtier de puce semi-conductrice selon la revendication 3, dans lequel le cadre de montage comprend une pastille de puce (11a), un contact de conducteur de grille (11g), un contact de conducteur de source (11s) et un contact de conducteur de drain (11d) qui sont physiquement séparés les uns des autres, et dans lequel le contact de conducteur de grille (11g) comprend la seconde rainure.

5. Boîtier de puce semi-conductrice selon la revendication 1, dans lequel le cadre de montage présente une pastille de puce (11a) destinée à supporter la puce semi-conductrice et un contact de conducteur de drain (11d) physiquement séparé de la pastille de puce.

6. Boîtier de puce semi-conductrice selon la revendication 5, dans lequel la puce semi-conductrice présente une grille (G), une source (S) et un drain (D), le drain est situé sur un côté de la puce semi-conductrice, la grille et la source sont situées sur un côté opposé de la puce semi-conductrice, et le drain est couplé au contact de conducteur de drain (11d) par le biais de l'adhésif (13), de la pastille de puce (11a) et d'un fil (11dw).

7. Boîtier de puce semi-conductrice selon la revendication 1, dans lequel la seconde partie comprend une partie métallique.

8. Boîtier de puce semi-conductrice selon la revendication 1, dans lequel la seconde partie du support comprend une première borne externe (11sm), une deuxième borne externe (11gm) et une troisième borne externe (11dm) du boîtier de puce semi-conductrice.

9. Boîtier de puce semi-conductrice selon la revendication 6, dans lequel le contact de conducteur de drain (11d) est configuré pour coupler le drain de la puce semi-conductrice (11) à une borne externe (11dm) incluse dans le support (20).

10. Boîtier de puce semi-conductrice selon une quelconque revendication précédente, dans lequel une largeur (w1) de la première rainure n'est pas supérieure à une largeur (w2) de la puce semi-conductrice.

11. Procédé de fabrication d'un boîtier de puce semi-conductrice (1a), comprenant :
l'obtention d'un cadre de montage (10) présentant une première surface (101) et une seconde surface (102) opposées l'une à l'autre, le cadre de montage présentant une première rainure (11ar) en retrait par rapport à la première surface du cadre de montage ;
le remplissage de la première rainure (11ar) avec un adhésif (13) ; et
la disposition d'une puce semi-conductrice (11) sur la première surface (101) du cadre de montage et sur l'adhésif (13) ;
le recouvrement du cadre de montage (10) et de la puce semi-conductrice (11) avec un encapsulant (14) ;
**caractérisé en ce que** le procédé comprend en outre :
la disposition d'un support (20) sur la seconde surface (102) du cadre de montage (10), dans lequel le support présente une première partie (20c) et une seconde partie (20m) séparées l'une de l'autre par le biais d'une couche isolante (30), dans lequel un coefficient de conductivité thermique de la première partie est supérieur à un coefficient de conductivité thermique de la seconde partie, dans lequel la première partie du support chevauche la puce semi-conductrice et la seconde partie du support ne chevauche pas la puce semi-conductrice, dans lequel la couche isolante est en contact avec une partie de l'encapsulant, et dans lequel la première partie comprend une partie en céramique et le coefficient de conductivité thermique de la première partie est supérieur à 100 Wm⁻¹K⁻¹.

12. Procédé de fabrication selon la revendication 11, comprenant en outre :
la fixation du cadre de montage sur le support à l'aide d'une attache (21).

13. Procédé de fabrication selon la revendication 12, dans lequel le procédé de fabrication comprend en outre :
après avoir disposé le support (20) sur la seconde surface (102) du cadre de montage (10), le retrait d'une partie de la seconde partie (20m) du support de sorte que la seconde partie ne soit pas en contact avec la première partie (20c).

14. Procédé de fabrication selon la revendication 13, dans lequel :
le retrait de la partie de la seconde partie (20m) du support comprend : la formation de la seconde partie en une première borne externe (12sm), une deuxième borne externe (12gm) et une troisième borne externe (11dm) qui sont séparées les unes des autres.

15. Procédé de fabrication selon la revendication 11, comprenant en outre :
le couplage d'un drain de la puce semi-conductrice à un contact de conducteur de drain du cadre de montage par le biais d'un fil,
dans lequel l'encapsulant remplit une seconde rainure (11gr) en retrait par rapport à la seconde surface (102) du cadre de montage (10).
